# EUROPEAN PATENT SPECIFICATION

(11) **EP 1 981 046 B1**
(45) Date of publication and mention of the grant of the patent: **15.02.2012**
(21) Application number: 06832999.4
(22) Date of filing: 21.11.2006
(51) Int. Cl.: H01G 4/30, H01G 4/12

(54) **METHOD FOR REGULATING CAPACITANCE VALUE OF BUILT-IN CAPACITOR IN MULTILAYERED CERAMIC SUBSTRATE, AND MULTILAYERED CERAMIC SUBSTRATE AND PROCESS FOR PRODUCING THE SAME**
VERFAHREN ZUM REGULIEREN DES KAPAZITÄTSWERTS EINES EINGEBAUTEN KONDENSATORS IN EINEM MEHRSCHICHTIGEN KERAMIKSUBSTRAT, UND MEHRSCHICHTIGES KERAMIKSUBSTRAT UND DESSEN HERSTELLUNGSPROZESS
PROCÉDÉ DE RÉGULATION DE VALEUR DE CAPACITANCE D'UN CONDENSATEUR INTÉGRÉ DANS UN SUBSTRAT CÉRAMIQUE MULTICOUCHE, ET SUBSTRAT CÉRAMIQUE MULTICOUCHE ET SON PROCEDE DE FABRICATION

(30) Priority: 30.01.2006 JP 2006021218
(43) Date of publication of application: 15.10.2008
(73) Proprietor: MURATA MANUFACTURING CO., LTD., Nagaokakyo-shi, Kyoto 617-8555 (JP)
(72) Inventor: OHAGA, Satoshi, Nagaokakyo-shi, Kyoto-fu 617-8555 (JP); SUGIMOTO, Yasutaka, Nagaokakyo-shi, Kyoto-fu 617-8555 (JP)
(74) Representative: Zimmermann, Tankred Klaus
(86) International application number: PCT/JP2006/323149
(87) International publication number: WO 2007/086184

(56) References cited:
- EP-A2- 1 517 596
- WO-A1-2006/046361
- JP-A- 10 055 933
- JP-A- 2005 328 396
- US-A1- 2004 144 476

## Description

### Technical Field

The present invention relates to a method for regulating the capacitance value of a capacitor to be built in a multilayer ceramic substrate, and a multilayer ceramic substrate and a method for manufacturing the same, and more particularly relates to a method for regulating the capacitance value of a built-in capacitor by laser trimming.

### Background Art

In recent years, in information processing apparatuses represented, for example, by a mobile communication terminal and a personal computer, an increase in information processing speed, miniaturization of an apparatus, enhancement of multifunctionality, and the like have been actively pursued, and the improvement in performances of the information processing apparatuses as described above has been realized primarily by an increase in integration, an increase in processing speed, and enhancement of functionality of semiconductor devices, such as VLSI and ULSI.

However, even though the increase in processing speed and enhancement of functionality of semiconductor devices have been accomplished, signal delay, crosstalk, impedance mismatch, noise generation caused by fluctuation of power source output, and the like may occur on a substrate on which devices are connected to each other, and as a result, the system performance may be limited in some cases.

Accordingly, as an electronic component used in a high speed and high performance information processing apparatus, a so-called multichip module (MCM: Multi-Chip Module) in which a plurality of semiconductor devices is mounted on a ceramic substrate has been practically used. As a substrate for the module as described above, a multilayer ceramic substrate on which a wiring pattern for electrically connecting semiconductor devices in a three-dimensional manner is provided is effectively used, and as a material for this type of multilayer ceramic substrate, alumina has been used.

In a multilayer ceramic substrate using alumina, since a sintering temperature of an alumina powder is high, such as 1,500°C or more, as a material for an inner layer wiring pattern, a high melting point metal, such as tungsten or molybdenum, must be used. However, since the high melting point metals as described above have a high specific resistance, the loss of signal increases, particularly in a high frequency region.

In order to solve the above problem, a multilayer ceramic substrate has been developed which is formed by laminating a plurality of glass ceramic green sheets, followed by sintering. Since the glass ceramic green sheets are formed by adding a vehicle containing a binder, a solvent, and the like to a ceramic powder and a glass powder, followed by mixing, and the sintering temperature is 1,050°C or less, simultaneous firing can be performed with a low temperature melting point metal, such as silver or copper, having a low specific resistance, and a multilayer ceramic substrate having a small signal loss in a high frequency region and superior electrical properties can be obtained.

In addition, in recent years, an attempt has been made in which a passive element, such as a capacitor, mounted on a multilayer ceramic substrate as a surface mounting element is built in a multilayer ceramic substrate so that an entire module is further miniaturized.

In the case in which the element as described above is built in a multilayer ceramic substrate, when electrical properties of the element is degraded as compared to that of a surface mounting element mounted on a substrate surface, the merit obtained by a built-in element is reduced by approximately half; hence, it is required that a built-in element have properties equal to or more than those of an element mounted on a substrate. Hence, as a substrate material which is used as a base, in general, a material is selected so that sufficient electrical properties of each built-in element can be obtained.

For example, in Japanese Unexamined Patent Application Publications Nos. 9-92983 (Patent Document 1) and 2000-58381 (Patent Document 2), a capacitor-built-in multilayer ceramic substrate has been disclosed having the structure in which a capacitor is built in, and in which for forming the capacitor, a dielectric ceramic layer having a high dielectric constant is provided between capacitor electrodes. As described above, when a dielectric ceramic layer having a high dielectric constant is provided between capacitor electrodes, even if the areas of capacitor electrodes are each small, a built-in capacitor having a high capacitance can be formed.

Incidentally, the capacitance value of a capacitor built in a multilayer ceramic substrate may vary lot by lot in some cases because of, for example, the variation in thickness of ceramic green sheets, the variation in printed area of capacitor electrodes, the variation generated when ceramic green sheets are laminated to each other, and the variation in shrinkage which occurs when ceramic green sheets are fired. Accordingly, in order to achieve a highly precise capacitance value of a built-in capacitor, it is necessary to perform trimming of a capacitor electrode with laser or the like. That is, it is necessary that by milling the area of a capacitor electrode using laser trimming, the capacitance value of a built-in capacitor be set to a desired value.

However, when laser trimming is performed, a dielectric ceramic layer provided between capacitor electrodes is partly milled besides the capacitor electrode, and as a result, after the trimming is performed, the insulation resistance between the capacitor electrodes may decrease and/or the Q value of the capacitor may decrease in some cases.
Patent Document 1: Japanese Unexamined Patent Application Publication No. 9-92983
Patent Document 2: Japanese Unexamined Patent Application Publication No. 2000-58381

US 2004/144476 A1 discloses a method of producing a ceramic multilayer substrate. After a resistor and/or a capacitor are simultaneously fired on a fired ceramic core substrate to be fired, the fired resistor and/or the fired capacitor is trimmed so that the resistance and the capacitance are adjusted. Thereafter, an after-lamination green sheet is laminated onto the ceramic core substrate and the produced after-lamination substrate is fired at a temperature which is lower than the sintering temperature of the resistor and the dielectric.

### Disclosure of Invention

### Problems to be Solved by the Invention

The present invention has been conceived in consideration of the above-described situation, and an object of the present invention is to provide a method for regulating the capacitance value of a built-in capacitor, which can precisely regulate the capacitance value of a built-in capacitor without significantly changing the insulation resistance and Q value before and after laser trimming.

Another object of the present invention is to provide a multilayer ceramic substrate obtained by using the above method for regulating the capacitance value of a built-in capacitor.

Still another object of the present invention is to provide a method for manufacturing a multilayer ceramic substrate, which is performed by using the above method for regulating the capacitance value of a built-in capacitor.

### Means for Solving the Problems

The present invention is first directed to a method for regulating the capacitance value f a built-in capacitor of a multilayer ceramic substrate which is defined by the features of claim 1 and includes: a ceramic laminate having a plurality of ceramic layers laminated to each other; and a first and a second capacitor electrode disposed to face each other with a specific one of the ceramic layers interposed therebetween so as to form the built-in capacitor.

The method for regulating the capacitance value of a built-in capacitor, according to the present invention, includes the step of performing laser trimming of the first capacitor electrode, and the specific ceramic layer disposed between the first and the second electrodes is a. TiO₂-based dielectric glass ceramic layer which contains 10 to 35 percent by volume of dielectric grains including TiO₂.

In the method for regulating the capacitance value of a built-in capacitor, according to the present invention, the TiO₂-based dielectric glass ceramic layer preferably has a layer thickness of 12.5 to 50 µm.

The first and the second capacitor electrodes may both be built in the ceramic laminate.

The TiO₂-based dielectric glass ceramic layer includes:
(A) 10 to 35 percent by volume of a BaO-TiO₂-ReO_{3/2}-based ceramic represented by xBaO-yTiO₂-zReO_{3/2} (where x, y, and z each indicate molar percent; 8≤x≤18, 52.5≤y≤65, and 20≤z≤40 hold; x+y+z=100 holds; and Re indicates a rare earth element);
(B) 5 to 42 percent by volume of an alumina ceramic; and
(C) 50 to 79 percent by volume of a borosilicate glass which includes 4 to 17.5 percent by weight of B₂O₃, 28 to 50 percent by weight of SiO₂, 0 to 20 percent by weight of A₂O₃, and 36 to 50 percent by weight of MO (where MO is at least one selected from the group consisting of CaO, MgO, SrO, and BaO), and in addition,
the TiO₂-based dielectric glass ceramic layer is preferably formed by firing a glass ceramic composition including the BaO-TiO₂-ReO_{3/2}-based ceramic and the alumina ceramic in a total amount of 21 percent by volume or more.

In the above glass ceramic composition, the borosilicate glass may further include less than 0.5 percent by weight of at least one selected from the group consisting of Li₂O, Na₂O, and K₂O.

In addition, the present invention is also directed to a method for manufacturing a multilayer ceramic substrate as defined by the features of claim 5, including the steps of: forming a multilayer ceramic substrate before being processed by trimming, which includes a ceramic laminate having a plurality of ceramic layers laminated to each other, and a first and a second capacitor electrode disposed to face each other with a specific one of the ceramic layers interposed therebetween so as to form a built-in capacitor; and performing laser trimming of the first capacitor electrode in order to regulate the capacitance value of the built-in capacitor.

According to the method for manufacturing a multilayer ceramic substrate of the present invention, in the step of forming a multilayer ceramic substrate before being processed by trimming, the specific ceramic layer located between the first and the second capacitor electrodes is formed of a TiO₂-based dielectric glass ceramic layer in which the content of dielectric grains including TiO₂ is 10 to 35 percent by volume.

Furthermore, the present invention is also directed to a multilayer ceramic substrate defined by the features of claim 6 and including: a ceramic laminate having a plurality of ceramic layers laminated to each other; and a first and a second capacitor electrode disposed to face each other with a specific one of the ceramic layers interposed therebetween so as to form a built-in capacitor.

In the multilayer ceramic substrate according to the present invention, the specific ceramic layer located between the first and the second capacitor electrodes is a TiO₂-based dielectric glass ceramic layer in which the content of dielectric grains including TiO₂ is 10 to 35 percent by volume, and the first capacitor electrode may have a trimming track formed when the built-in capacitor is processed by laser trimming.

### Advantages

According to the method for regulating the capacitance value of a built-in capacitor of the present invention, when the first capacitor electrode is processed by laser trimming in order to regulate the capacitance value of a built-in capacitor, since the ceramic layer provided between the first and the second capacitor electrodes is a TiO₂-based dielectric glass ceramic layer in which the content of the dielectric grains (hereinafter referred to as "TiO₂-based dielectric grains" in some cases) including TiO₂ is 10 to 35 percent by volume, the insulation resistance between the capacitor electrodes and the Q value of the capacitor are not significantly changed before and after the laser trimming, and the capacitance value of the built-in capacitor can be precisely regulated.

That is, the changes in insulation resistance and Q value are induced by the change in properties, which is caused by the laser trimming, of the dielectric glass ceramic layer between the capacitor electrodes and are particularly induced by semiconductorization of the TiO₂-based dielectric grains of the dielectric glass ceramic layer. Hence, by specifying the ratio (volume ratio) of the TiO₂-based grains which are responsible for the change in properties, without substantially degrading the insulation resistance and the Q value, the capacitance value of the built-in capacitor can be precisely regulated.

In addition, according to the method for manufacturing a multilayer ceramic substrate of the present invention, when the method for regulating the capacitance value of a built-in capacitor, according to the present invention, is used, a multilayer ceramic substrate which includes a built-in capacitor having superior insulation resistance and Q value can be manufactured with good reproducibility.

In addition, the multilayer ceramic substrate according to the present invention is obtained by using the method for regulating the capacitance value of a built-in capacitor of the present invention. Hence, according to the multilayer ceramic substrate of the present invention, in the built-in capacitor provided therein, the capacitance value is precisely regulated, and further, the insulation reliability and the Q value can also be made excellent.

### Brief Description of Drawings

Fig. 1 includes cross-sectional views each schematically showing part of a multilayer ceramic substrate 1 for illustrating a method for regulating the capacitance value of a built-in capacitor according to the present invention.
Fig. 2 is a view corresponding to that shown in Fig. 1 for illustrating a comparative example of the method for regulating the capacitance value of a built-in capacitor according to the present invention.
Fig. 3 is a cross-sectional view schematically showing a multilayer ceramic substrate 21 of one embodiment according to the present invention.
Fig. 4 is an exploded perspective view of a lumped-constant isolator 41 as one example of a nonreciprocal circuit device having a multilayer ceramic substrate 44 according to another embodiment of the present invention.
Fig. 5 is an equivalent circuit of the lumped-constant, isolator 41 shown in Fig. 4.
Fig. 6 is a graph showing the rate of change in insulation resistance and the rate of change in Q value with respect to the content (volume percent) of a BaO-Re₂O₃-4TiO₂-based dielectric glass ceramic.

### Reference Numerals

1, 21, 44 multilayer ceramic substrate
2, 33 built-in capacitor
3 to 5, 22, 23 ceramic layer
6, 24 ceramic laminate
7, 26 first capacitor electrode
8, 27 second capacitor electrode
9 TiO₂-based dielectric grain
10 laser light
11, 34 trimming track

### Best Modes for Carrying Out the Invention

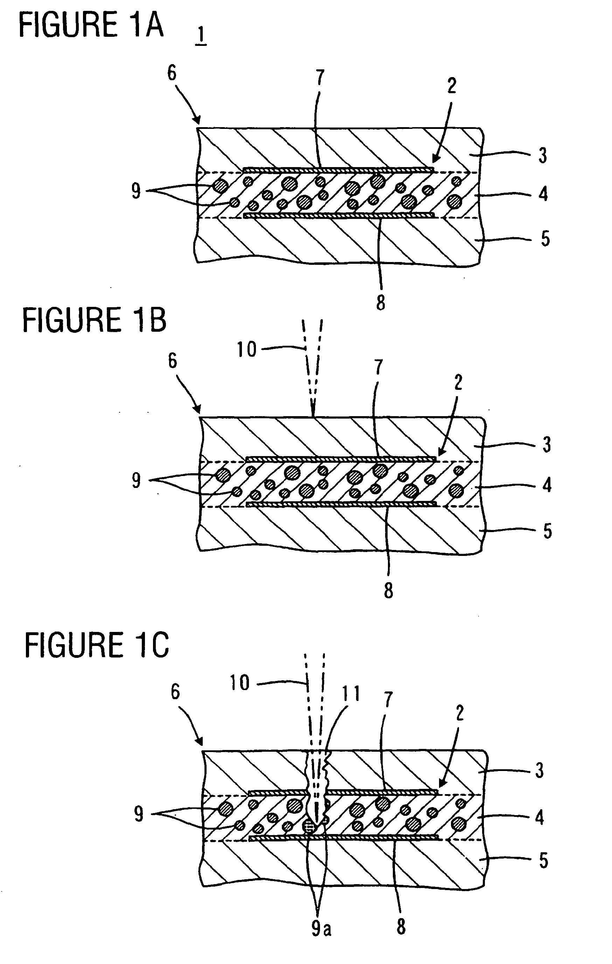

First, with reference to Fig. 1, a method for regulating the capacitance value of a built-in capacitor, according to the present invention, will be described in detail. In Fig. 1, schematic cross-sectional views are shown each indicating part of a multilayer ceramic substrate 1 in which a built-in capacitor 2 is formed.

As shown in Fig. 1(A), the multilayer ceramic substrate 1 has a ceramic laminate 6 formed of ceramic layers 3, 4, and 5 laminated to each other, and in the ceramic laminate 6, the built-in capacitor 2 is formed. The built-in capacitor 2 is formed of a first capacitor electrode 7, a second capacitor electrode 8 disposed to face the first capacitor electrode 7, and the ceramic layer 4 provided between the first and the second capacitor electrodes 7 and 8. The above ceramic layer 4 is a dielectric glass ceramic layer and is a dielectric layer including TiO₂-based dielectric grains 9, and the ratio of the TiO₂-based grains 9 is set to 10 to 35 percent by volume.

The capacitance value of the capacitor 2 built in the multilayer ceramic substrate 1 may vary lot by lot in some cases because of, for example, the variation in thickness of a ceramic green layer to be formed into the glass ceramic layer 4, the variation in screen printed area of conductor patterns to be formed into the first and the second capacitor electrodes 7 and 8, the variation generated when ceramic green sheets are laminated to each other, and the variation in shrinkage which occurs when ceramic green sheets are fired. Accordingly, in order to set the capacitance value of the built-in capacitor 2 to a desired value, as shown in Fig. 1(B), by using YAG (Yttrium Aluminum Garnet) laser or the like, laser light 10 is irradiated to the first capacitor electrode 7 in the ceramic laminate 6 provided in the multilayer ceramic substrate 1.

Accordingly, as shown in Fig. 1(C), by the laser light 10 thus irradiated, the first capacitor electrode 7 is milled together with the ceramic layer 3, and a processed hole (trimming track) 11 is formed. As a result, part of the first capacitor electrode 7 is milled, and in addition, in this step, the processed hole 11 reaches part of the dielectric glass ceramic layer 4; hence, the dielectric glass ceramic layer 4 is also partly milled.

In this embodiment, the dielectric glass ceramic layer 4 having a high dielectric constant is formed, for example, of a titanium oxide-based material, such as barium titanate, calcium titanate, or strontium titanate, and in the above materials, a titanium oxide-based crystalline phase (TiO₂-based dielectric grains), such as a BaTiO₃ crystalline phase, a CaTiO₃ crystalline phase, or a SrTiO₃ crystalline phase, is a primary crystalline phase. In addition, since heat generated by the irradiation of the laser light 10 instantaneously reaches 2,000°C, when this heat is applied to the TiO₂-based dielectric grains 9 in the dielectric glass ceramic layer 4, tetravalent titanium forming the TiO₂-based dielectric grains 9 is reduced to trivalent titanium (Ti⁴⁺ → Ti³⁺) .

As a result, oxygen holes are formed in the dielectric grains 9, and the dielectric grains 9 are semiconductorized. That is, by the laser trimming, part of the TiO₂-based dielectric grains 9, which is in the vicinity of the place irradiated with the laser light 10, is changed to semiconductorized TiO₂-based dielectric grains 9a.

As for the above semiconductorization, according to the present invention, since the ratio of the TiO₂-based dielectric grains 9 in the TiO₂-based dielectric glass ceramic layer 4 is low, such as 10 to 35 percent by volume, even when the TiO₂-based dielectric grains 9 are semiconductorized, the semiconductorized dielectric grains 9a are not connected to each other between the first capacitor electrode 7 and the second capacitor electrode 8 as shown in Fig. 1(C); hence, even after the laser trimming, the insulation resistance and the Q value hardly decrease.

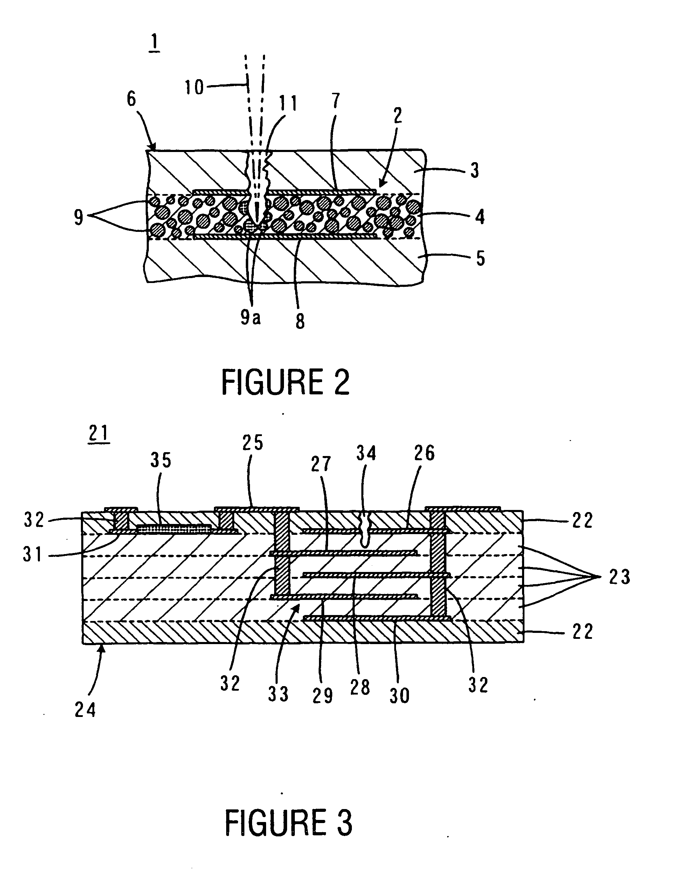

Fig. 2 is a view for illustrating a comparative example of the method for regulating a built-in capacitor according to the present invention, the view being corresponding to Fig. 1. In Fig. 2, elements corresponding to those shown in Fig. 1 are designated by reference numerals similar to those described above, and duplicated description is omitted.

In the case in which the ratio of the TiO₂-based dielectric grains 9 in the TiO₂-based dielectric glass ceramic layer 4 is more than 35 percent by volume, since the ratio of the TiO₂-based dielectric grains 9 becomes excessively large, when the dielectric grains 9 are semiconductorized, as shown in Fig. 2, the semiconductorized dielectric grains 9a are connected to each other between the first capacitor electrode 7 and the second capacitor electrode 8.

As a result, by the laser trimming, the first capacitor electrode 7 and the second capacitor electrode 8 are shortcircuited therebetween, and hence the insulation resistance is significantly decreased. In addition, when the insulation properties of the dielectric glass ceramic layer 4 are degraded, loss of Joule heat occurs thereby, and the Q value of the capacitor decreases. The semiconductorized dielectric grains 9a can be returned to the original state by performing a re-oxidation treatment; however, in this case, the re-oxidation treatment is necessarily performed as an additional treatment, and in addition, by the re-oxidation treatment, the insulation resistance and the Q value of the built-in capacitor 2 are again changed, so that the variation may occur in some cases.

As described above, according to the present invention, in the TiO₂-based dielectric glass ceramic layer 4, since the ratio of the TiO₂-based dielectric grains 9 is 10 to 35 percent by volume, the insulation resistance between the capacitor electrodes 7 and 8 and the Q value of the built-in capacitor 2 are not significantly changed before and after the laser trimming, and in addition, without performing an additional treatment, such as a re-oxidation treatment, the capacitance value of the built-in capacitor 2 can be precisely regulated.

In addition, the relative dielectric constant of the TiO₂-based dielectric glass ceramic layer 4 primarily depends on the volume ratio of the TiO₂-based dielectric grains 9 present therein, and when the ratio of the TiO₂-based dielectric grains 9 is less than 10 percent by volume, as the dielectric glass ceramic layer 4 forming the built-in capacitor 2, a sufficient relative dielectric constant εᵣ cannot be obtained. By the reasons as described above, the volume ratio of the TiO₂-based dielectric grains 9 is required to be in the range of 10% to 35%, and in addition, in this range, a volume ratio of 20% to 35% is particularly preferable. In addition, the grain diameter (D50) of the TiO₂-based dielectric grains 9 is preferably in the range of 0.9 to 2.5 µm and is more preferably in the range of 1.0 to 1.5 µm.

In addition, the layer thickness (element thickness) of the TiO₂-based dielectric glass ceramic layer 4 is preferably in the range of 12.5 to 50 µm. When the layer thickness is less than 12.5 µm, even when the occupation ratio of the TiO₂-based dielectric grains 9 is set as described above, the insulation resistance and/or the Q value may be changed in some cases before and after the laser trimming. In addition, when the layer thickness is more than 50 µm, since the distance between the capacitor electrodes 7 and 8 is excessively large, it becomes difficult to obtain a high capacitance value of the built-in capacitor 2.

As for the positions of the first and the second capacitor electrodes 7 and 8, these two electrodes may be built in the ceramic laminate 6 as shown in Fig. 1. When the first capacitor electrode 7 to be processed by trimming is formed inside the ceramic laminate 6, compared to the case in which the first capacitor electrode 7 is disposed on the surface of the ceramic laminate 6, laser light 10 having a large power must be irradiated; however, even if the laser light 10 having a large power is used, when the occupation ratio of the TiO₂-based dielectric grains 9 in the TiO₂-based dielectric glass ceramic layer 4 is specified as described above, without significantly changing the insulation resistance and the Q value, the capacitance value of the built-in capacitor 2 can be precisely regulated.

In the multilayer ceramic substrate 1 described above, the ceramic layers 3 and 5 may be formed of a material similar to that for the TiO₂-based dielectric glass ceramic layer 4; however, another ceramic material having a low relative dielectric constant, such as a low-temperature sinterable ceramic (LTCC, Low Temperature Co-fired Ceramic) material, is preferably used. The low-temperature sinterable ceramic material is a ceramic material which can be sintered at a temperature of 1,050°C or less and which can be co-fired with silver, copper, or the like having a low specific resistance. As the low-temperature sinterable ceramic material, in particular, for example, there may be mentioned a glass composite-based LTCC material formed by mixing a borosilicate glass with a powdered ceramic, such as alumina, zirconia, magnesia, or forsterite; a crystalline glass-based LTCC material using a ZnO-MgO-Al₂O₃-SiO₂-based crystalline glass; and a non-glass-based LTCC material such as a BaO-Al₂O₃-SiO₂-based powder ceramic or an Al₂O₃-CaO-SiO₂-MgO-B₂O₃-based powder ceramic.

The TiO₂-based dielectric glass ceramic layer 4 preferably includes:
(A) 10 to 35 percent by volume of a BaO-TiO₂-ReO₃n-based ceramic represented by xBaO-yTiO₂-zReO_{3/2} (where x, y, and z each indicate molar percent; 8≤x≤18, 52.5≤y≤65, and 20≤z≤40 hold; x+y+z=100 holds; and Re indicates a rare earth element);
(B) 5 to 42 percent by volume of an alumina ceramic; and
(C) 50 to 79 percent by volume of a borosilicate glass which includes 4 to 17.5 percent by weight of B₂O₃, 28 to 50 percent by weight of SiO₂, 0 to 20 percent by weight of Al₂O₃, and 36 to 50 percent by weight of MO (where MO is at least one selected from the group consisting of CaO, MgO, SrO, and BaO), and
the TiO₂-based dielectric glass ceramic layer is preferably formed by firing a glass ceramic composition containing the BaO-TiO₂-ReO_{3/2}-based ceramic and alumina in a total amount of 21 percent by volume or more.

From the glass ceramic composition as described above, a sintered body can be formed to have a relatively high relative dielectric constant, and in addition, when a ceramic substrate incorporating a resistance element therein is formed, the resistance properties of the resistance element are not degraded.

In the above glass ceramic composition, the BaO-TiO₂-ReO_{3/2}-based ceramic represented by xBaO-yTiO₂-zReO_{3/2} is formed into the TiO₂-based dielectric grains 9 by firing. In this glass ceramic composition, when the ratio of the alumina ceramic is less than 5 percent by volume, the flexural strength of the multilayer ceramic substrate 1 after firing tends to decrease, and on the other hand, when the above ratio is more than 42 percent by volume, since the ratio of the BaO-TiO₂-ReO_{3/2}-based ceramic decreases, a relative dielectric constant necessary as the built-in capacitor 2 may not be obtained in some cases.

In addition, when the ratio of the borosilicate glass is less than 50 percent by volume, the sintering properties of the multilayer ceramic substrate 1 may be insufficient in some cases, and on the other hand, when the above ratio is more than 79 percent by volume, since the ratio of the BaO-TiO₂-ReO_{3/2}-based ceramic relatively decreases, a relative dielectric constant necessary as the built-in capacitor 2 may not be obtained in some cases.

In addition, when the total amount of the BaO-TiO₂-ReO_{3/2}-based ceramic and the alumina ceramic is less than 21 percent by volume, since the ratio of the BaO-TiO₂-ReO_{3/2}-based ceramic relatively decreases, a relative dielectric constant necessary as the built-in capacitor 2 may not be obtained in some cases, and in addition, the flexural strength also tends to decrease.

In addition, although being described in detail in PCT International Publication No. W02006/046361 Pamphlet by the inventors of the present invention, in the BaO-TiO₂-ReO_{3/2}-based ceramic represented by xBaO-yTiO₂-zReO_{3/2}, when x is less than 8, the relative dielectric constant and the Q values decrease, and in addition, the absolute value of a temperature coefficient of capacitance (TCC) of the relative dielectric constant may increase in some cases. On the other hand, when x is more than 18, the Q value decreases, and in addition, the absolute value of TCC also tends to increase. In addition, when y is less than 52.5, the relative dielectric constant may decrease in some cases, and on the other hand, when y is more than 65, the absolute value of TCC tends to increase. In addition, when z is less than 20, the absolute value of TCC may increase in some cases; on the other hand, when z is more than 40, the absolute value of TCC increases, and in addition, the relative dielectric constant also tends to decrease. In addition, as Re (rare earth element), Nd, Pr, Sm, or the like may be used.

In the borosilicate glass, when the content of B₂O₃ is less than 4 percent by weight, the sintering properties may become insufficient in some cases, and on the other hand, when the content is more than 17.5 percent by weight, since the humidity resistance degrades, PCT (Pressure Cooker Test) reliability degrades, and dielectric breakdown may occur. In addition, when the content of SiO₂ is less than 28 percent by weight, since the humidity resistance degrades as is the case described above, the PCT reliability degrades, and dielectric breakdown may occur. On the other hand, when the content of SiO₂ is more than 50 percent by weight, the sintering properties tend to be insufficient.

In addition, in the borosilicate glass, Al₂O₃ may not be contained; however, Al₂O₃ is preferably contained since the humidity resistance is improved. However, when the content of Al₂O₃ is more than 20 percent by weight, the Q value tends to decrease.

In addition, in the borosilicate glass, when the content of MO is less than 36 percent by weight, the sintering properties may be insufficient in some cases, and on the other hand, when the content is more than 50 percent by weight, since the humidity resistance degrades, the PCT reliability degrades, and hence dielectric breakdown may occur. Although at least one selected from the group consisting of CaO, MgO, SrO, and BaO may be used as MO, in order to obtain a high Q value of the dielectric glass ceramic layer 4, in particular, CaO is preferably used.

In addition, the borosilicate glass preferably further contains at least one selected from the group consisting of Li₂O, Na₂O, and K₂O in an amount of less than 0.5 percent by weight. When at least one of these alkali metal oxides is contained in the range described above, a high relative dielectric constant can be obtained. When the content of the alkali metal oxide is more than 0.5 percent by weight, the humidity resistance tends to degrade.

The above glass ceramic composition may further contain 20 percent by weight or less of CaTiO₃. When CaTiO₃ in the range described above is contained, a high relative dielectric constant can be obtained. In addition, when the content of CaTiO₃ is more than 20 percent by weight, the absolute value of TCC tends to increase.

In addition, the glass ceramic composition may further contain 3 parts by weight or less of CeO₂ with respect to 100 parts by weight of the total of the BaO-TiO₂-ReO_{3/2}-based ceramic, the alumina ceramic, and the borosilicate glass. When CeO₂ is contained in the range described above, and Ag is used as an electrode material, discoloration of part of a substrate in the vicinity of the electrode, which is caused by colloid formation of Ag used as an electrode material, can be suppressed. In addition, when the content of Ce₂O is more than 3 percent by weight, the Q value of the dielectric glass ceramic layer tends to decrease.

In addition, when at least one of TiO₂ and ZrO₂ in an amount of 1 percent by weight or less is added to the glass ceramic composition, the absolute value of the rate of change in temperature of relative dielectric constant of a sintered body can be decreased which is obtained by sintering the above composition. Since this TiO₂ is to be contained in the TiO₂-based dielectric grains 9 of the TiO₂-based dielectric glass ceramic layer 4 after the firing, in consideration of the ratio of the grains formed of this TiO₂, the amount of the TiO₂-based dielectric grains 9 must be adjusted within the range described above.

Next, a concrete structure of the multilayer ceramic substrate according to the present invention and a method for manufacturing the same will be described.

As shown in Fig. 3, a multilayer ceramic substrate 21 has a ceramic laminate 24 formed of ceramic layers 22 and ceramic layers 23 laminated to each other. The ceramic layers 22 are each a ceramic layer formed of the low-temperature sinterable ceramic material described above, and the ceramic layers 23 are each the TiO₂-based dielectric glass ceramic layer described above.

Relating to the ceramic layers 22 and 23, conductive patterns primarily formed, for example, of Ag or Cu are provided. As the conductive patterns, there are several external conductors 25 formed on the external surface of the multilayer ceramic substrate 21, several interlayer conductors 26 to 31 formed along interfaces between the ceramic layers 22 and 23, and several via hole conductors 32 provided to penetrate specific layers of the ceramic layers 22 and 23.

Among the conductive patterns 25 to 32, besides patterns provided simply as wires, there are patterns provided to form at least one passive element, such as a capacitor and/or an inductor, inside the multilayer ceramic substrate 21. For example, the interlayer conductors 26 to 30 are to be formed into capacitor electrodes. From the capacitor electrodes 26 to 30 and the ceramic layers 23 disposed therebetween, a built-in capacitor 33 is formed. From the structure described above, it is understood that a built-in capacitor may be formed from at least three capacitor electrodes as well as from two capacitor electrodes. At least one of the capacitor electrodes 26 to 30 may also be used as a ground electrode.

In this multilayer ceramic substrate 21, a trimming track 34 remains which is formed by the above method for regulating the capacitance value of the above built-in capacitor 33. This trimming track 34 is formed by performing laser trimming of the capacitor electrode 26 from one primary surface side of the multilayer ceramic substrate 21 obtained by a general sheet lamination method or a thick film printing lamination method. In addition, the trimming track 34 may be filled with a glass or a resin in order to prevent the variation in capacitance which may occur after the capacitance regulation is performed.

In addition, a thick film resistor 35 is built in the multilayer ceramic substrate 21. The thick film resistor 35 is formed of a resistor film provided along the interface between the ceramic layers 22 and 23. This resistor film is formed by sintering a resistor paste including, for example, RuO₂ as a primary component and a silicate-based glass as an auxiliary component. When this thick film resistor 35 is processed by laser trimming to regulate the resistor value thereof, even if the ceramic layer 23 is partly milled, since the ceramic layer 23 is formed of the TiO₂-based dielectric glass ceramic layer described above, the change in properties before and after the trimming is small.

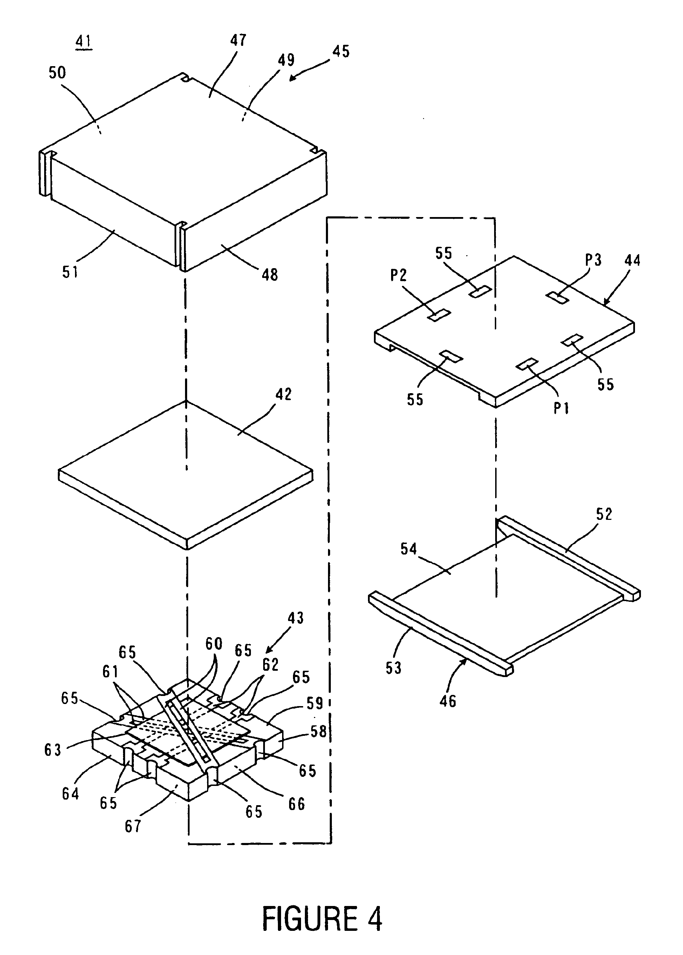

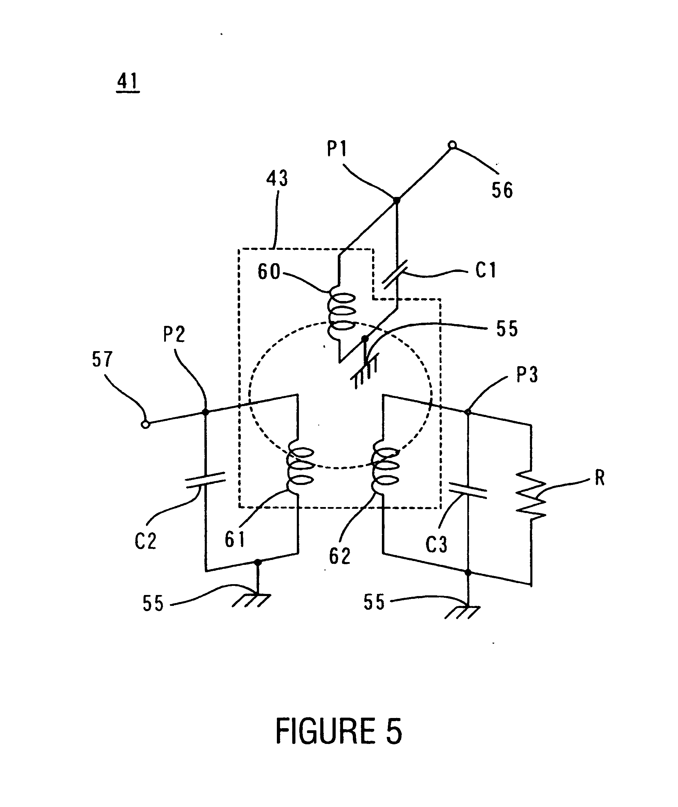

Next, one example of an electronic component formed by using the multilayer ceramic substrate according to the present invention will be described with reference to Figs. 4 and 5. Fig. 4 is an exploded perspective view showing a lumped-constant isolator 41 as one example of a nonreciprocal circuit device, and Fig. 5 is an equivalent circuit of the lumped-constant isolator 41.

As shown in Fig. 4, the lumped-constant isolator 41 includes a rectangular permanent magnet 42, a central electrode assembly 43, a mounting multilayer ceramic substrate 44, an upper side casing 45, and a lower side casing 46, the latter two casings each being used as a metal casing.

The upper side casing 45 has a box shape having an opening facing downward and is formed of an upper wall portion 47 and four side wall portions 48 to 51. The lower side casing 46 includes two standing walls 52 and 53 facing each other and a bottom wall portion 54 connecting between the standing walls 52 and 53. The upper side casing 45 and the lower side casing 46 are each formed of a ferromagnetic material, and the surfaces thereof are processed by Ag or Cu plating.

Hereinafter, with reference to Fig. 5 together with Fig. 4, the central electrode assembly 43 and the multilayer ceramic substrate 44 will be described in detail.

Although a mechanical structure of the multilayer ceramic substrate 44 is not shown in the figures, the multilayer ceramic substrate 44 has a multilayer structure which includes ceramic layers laminated to each other and which incorporates matching capacitor elements C1, C2, and C3 and a resistor element R as shown in Fig. 5. The built-in structures of the matching capacitor elements C1 to C3 and the resistor element R are substantially the same as those of the built-in capacitor 33 and the thick film resistor 35 in the multilayer ceramic substrate 21 shown in Fig. 3. In addition, although being not shown in the figure, trimming tracks of these passive elements remain in the multilayer ceramic substrate 44.

On the upper surface of the multilayer ceramic substrate 44, port electrodes P1, P2, and P3 and earth electrodes 55 are exposed. Although not being shown in Fig. 4, on the lower surface of the multilayer ceramic substrate 44, an input electrode 56 and an output electrode 57 electrically connecting this isolator 41 to an external circuit are formed.

The central electrode assembly 43 has a rectangular base 58 formed of microwave ferrite. On an upper surface 59 of the base 58, 3 central electrodes 60, 61, and 62 are disposed. These central electrodes 60 to 62 are insulated from each other by electrical insulating layers 63 provided therebetween. In addition, the three central electrodes 60 to 62 are disposed so as to cross each other with an angle of approximately 120°.

Although the order of placement of the central electrodes 60 to 62 may be arbitrarily determined, in the embodiment shown in Fig. 4, the central electrode 62, the electrical insulating layer 63, the central electrode 61, the electrical insulating layer 63, and the central electrode 60 are disposed in that order from the bottom. One-side ends of these central electrodes 60 to 62 are connected to an earth electrode 67 formed on a lower surface 66 of the base 58 through connection electrodes 65 formed on side surfaces 64 of the base 58, and the other-side ends of these central electrodes 60 to 62 are connected to the port electrodes P1 to P3 of the multilayer ceramic substrate 44 through the connection electrodes 65 formed on the side surfaces 64.

As described above, the earth sides of the central electrodes 60 to 62 are connected to the common earth electrode 67 through the connection electrodes 65. This common earth electrode 67 has a shape approximately the same as that of the lower surface 66 of the base 58 and covers almost an entire surface of the lower surface 66 so as not to be in contact with the port electrodes P1 to P3 formed on the multilayer ceramic substrate 44. In addition, the earth electrode 67 is connected to the earth electrodes 55 on the multilayer ceramic substrate 44.

When the lumped-constant isolator 41 is formed by using the constituent elements described above, first, the multilayer ceramic substrate 44 is set in the lower side casing 46, and the central electrode assembly 43 is placed on the multilayer ceramic substrate 44, so that a predetermined electrical connection is performed. In addition, the permanent magnet 42 is disposed at the lower surface side of the upper wall portion 47 of the upper side casing 45. Subsequently, while the state thus formed is maintained, the upper side casing 45 and the lower side casing 46 are connected to each other, so that a united metal casing is formed.

When the constituent elements are assembled as described above, the permanent magnet 42 applies a direct current magnetic field to the central electrode assembly 43. In this case, the metal casing composed of the upper side casing 45 and the lower side casing 46 forms a magnetic circuit and also functions as a yoke.

As described above, the multilayer ceramic substrate and the method for manufacturing the same, according to the present invention, may be applied to a nonreciprocal circuit device and a method for manufacturing the same, the nonreciprocal circuit device including a permanent magnet; a central electrode assembly which has a base, a plurality of central electrodes disposed on the base to cross each other with a predetermined crossing angle, and electrical insulating layers disposed between the central electrodes to electrically insulate therebetween, and which is applied with a direct current magnetic field by the permanent magnet; a casing accommodating the permanent magnet and the central electrode assembly; and a multilayer ceramic substrate mounting the central electrode assembly and provided with a capacitor element and a resistor element.

The multilayer ceramic substrate and the method for manufacturing the same, according to the present invention, may also be applied, besides a nonreciprocal circuit device and a method for manufacturing the same, to various module ceramic substrates and a method for manufacturing the same.

In addition, in the present invention, the capacitance regulation by laser trimming is not limited to milling of part of the first capacitor electrode, that is, is not limited to capacitance regulation by decreasing an electrode area, and for example, the capacitance regulation may be performed by dividing one first capacitor electrode into at least two parts. In addition, trimming of the second capacitor electrode may be simultaneously performed when laser trimming is performed for the first capacitor electrode.

Next, the present invention will be described in detail with reference to concrete experimental examples. However, the present invention is not limited to the following experimental examples.

### <Experimental Example 1>

First, in order to form a powdered BaO-TiO₂-ReO_{3/2}-based ceramic, BaCO₃, TiO₂, Nd₂O₃, and Sm₂O₃ powders were mixed together at a ratio, on a molar percent basis, of 13%, 58%, 10%, and 19%, respectively. Next, after a powdered starting material thus obtained by mixing was calcined for 1 hour at a temperature of 1,150°C, the calcined product was pulverized, so that the powdered BaO-TiO₂-ReO_{3/2}-based ceramic (hereinafter referred to as a "BRT powder" or a "BaO-Re₂O₃-4TiO₂-based ceramic powder" in some cases) was obtained.

Next, in order to form a powdered borosilicate glass, CaO, Al₂O₃, B₂O₃, and SiO₂ powders were mixed together at a ratio, on a weight percent basis, of 45%, 5%, 5%, and 45%, respectively. Subsequently, after a powdered starting material thus obtained by mixing was melted at a temperature of 1,100 to 1,400°C and was then charged into water for quenching, wet pulverization was performed, so that a powdered borosilicate glass was obtained.

Next, by using the powdered BaO-TiO₂-ReO_{3/2}-based ceramic, a powdered Al₂O₃ ceramic, and the powdered borosilicate glass, in order to obtain the composition ratio shown in the column "glass ceramic composition" in terms of the volume ratio after firing, these specific powdered ceramic and glass were weighed and were then sufficiently mixed together.

Subsequently, to the mixed powder thus obtained as described above, appropriate amounts of a binder, a plasticizer, and a solvent were added, followed by kneading, so that a slurry was obtained. Next, this slurry was formed by a doctor blade method into a sheet having a thickness of 50 µm. The obtained ceramic green sheet was cut into rectangular sheets having a size of 30 mm by 10 mm. Next, the rectangular ceramic green sheets were laminated and pressure-bonded to each other, so that laminates having a thickness of 0.5 to 1.0 mm were obtained.

In addition, in order to form a capacitor electrode pattern having a planar dimension of 1 mm by 1 mm used as the first capacitor electrode at a position from a surface layer by 0.05 mm and a capacitor electrode pattern having a planar dimension of 1 mm by 1 mm used as the second capacitor electrode at a position from the surface layer by 0.10 mm inside the laminate described above, on the ceramic green sheets before the lamination step was performed, conductive films were formed beforehand by using a Ag paste.

Next, the laminates thus obtained were fired at a temperature of 870°C for 1 hour, so that plate-shaped sintered bodies of Samples 1 to 25 were obtained.

Subsequently, the sintered bodies thus obtained were each processed by using YAG laser to irradiate the first capacitor electrode with laser light at an output of 2 kHz with a scan number of 7 (conditions of laser trimming), so that the first capacitor electrode was trimmed to decrease the capacitor's capacitance from 20 pF at the beginning to 10 pF.

Next, the insulation resistances (logIR) before and after the trimming were respectively measured, and by an LCR meter, the Q values at 1 MHz before and after the trimming were also respectively measured. In addition, the relative dielectric constant εᵣ of the dielectric glass ceramic layer after the trimming was measured by an LCR meter, and the flexural strength (MPa) of the dielectric glass ceramic layer after the trimming was also measured.

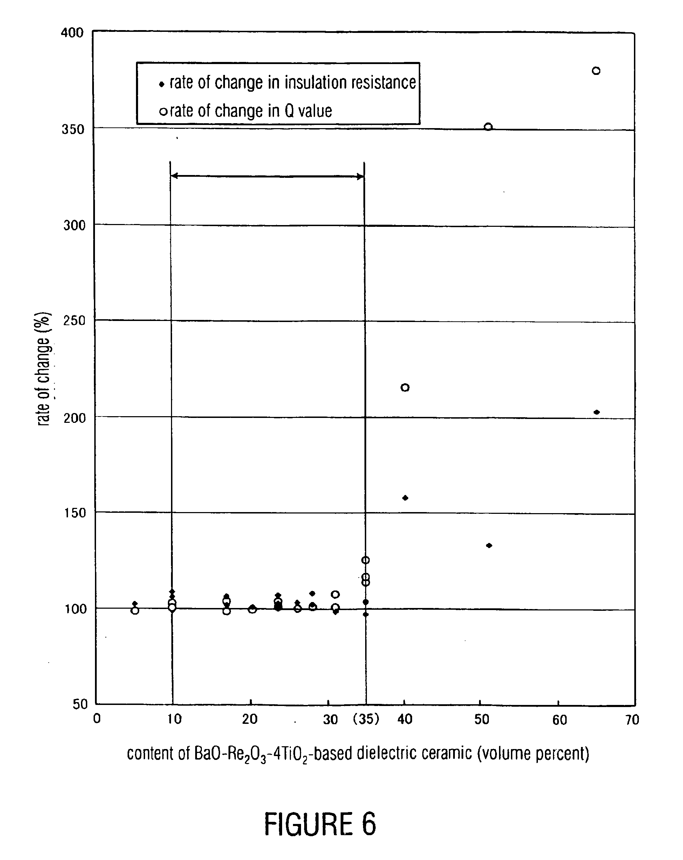

The results obtained by the individual measurements are shown in the following Table 1. In addition, in the column "judgment of trimming performance " in Table 1, "G" indicates that the rates of change in insulation resistance and Q value before and after trimming are 30% or less, and "NG" indicates that the rates of change in insulation resistance and Q value before and after trimming are more than 30%. In addition, Fig. 6 is a graph showing the rates of change in insulation resistance and Q value with respect to the content (volume percent) of the BaO-Re₂O₃-4TiO₂-based ceramic.

**Table 1**

| **SAMPLE NO.** | **GLASS CERAMIC COMPOSITION** | | | **INSULATION RESISTANCE (logIR)** | | | **Q VALUE at 1 MHz** | | | **JUDGMENT OF TRIMMING PERFORMANCE** | **RELATIVE DIELECTRIC CONSTANT** εᵣ | **FLEXURAL STRENGTH (MPa)** |
|---|---|---|---|---|---|---|---|---|---|---|---|---|
| | **BRT (VOLUME PERCENT)** | **Al₂O₃ (VOLUME PERCENT)** | **GLASS (VOLUME PERCENT)** | **BEFORE TRIMMING** | **AFTER TRIMMING** | **RATE OF CHANGE (%** | **BEFORE TRIMMING** | **AFTER TRIMMING** | **RATE OF CHANGE (%)** | | | |
| 1 | 5.0 | 32.0 | 63.0 | 13.13 | 12.81 | 102.5 | 1236 | 1251 | 98.8 | G | 8.5 | 312 |
| 2 | 10.0 | 5.0 | 85.0 | 12.78 | 12.91 | 99.0 | 1324 | 1319 | 100.4 | G | 8.1 | 283 |
| 3 | 10.0 | 11.0 | 79.0 | 13.45 | 11.83 | 113.7 | 1351 | 1326 | 101.9 | G | 10.4 | 293 |
| 4 | 10.0 | 24.9 | 65.1 | 12.86 | 12.99 | 99.0 | 1398 | 1371 | 102.0 | G | 11.6 | 301 |
| 5 | 10.0 | 40.0 | 50.0 | 12.75 | 11.85 | 107.6 | 1363 | 1350 | 101.0 | G | 10.7 | 308 |
| 6 | 10.0 | 50.0 | 40.0 | 12.38 | 12.41 | 99.8 | 1313 | 1295 | 101.4 | G | 8.9 | 286 |
| 7 | 17.0 | 15.1 | 67.9 | 13.24 | 12.29 | 107.7 | 1410 | 1425 | 98.9 | G | 13.2 | 282 |
| 8 | 17.0 | 27.0 | 56.0 | 13.12 | 12.88 | 101.9 | 1384 | 1309 | 105.7 | G | 13.5 | 290 |
| 9 | 20.2 | 10.6 | 69.2 | 12.91 | 12.77 | 101.1 | 1461 | 1458 | 100.2 | G | 15.1 | 287 |
| 10 | 23.5 | - | 76.5 | 12.52 | 12.50 | 100.2 | 1444 | 1419 | 101.8 | G | 16.6 | 255 |
| 11 | 23.5 | 5.9 | 70.6 | 13.25 | 12.87 | 103.0 | 1500 | 1491 | 100.6 | G | 16.9 | 281 |
| 12 | 23.5 | 18.5 | 58.0 | 12.85 | 11.99 | 107.2 | 1456 | 1435 | 101.5 | G | 17.2 | 286 |
| 13 | 23.5 | 26.5 | 50.0 | 12.93 | 12.70 | 101.8 | 1482 | 1421 | 104.3 | G | 16.8 | 282 |
| 14 | 23.5 | 31.5 | 45.0 | 12.70 | 12.44 | 102.1 | 1465 | 1409 | 104.0 | G | 17.0 | 291 |
| 15 | 26.0 | 2.4 | 71.6 | 12.54 | 12.13 | 103.4 | 1498 | 1501 | 99.8 | G | 18.2 | 264 |
| 16 | 28.0 | 5.0 | 67.0 | 13.05 | 12.09 | 107.9 | 1521 | 1485 | 102.4 | G | 19.2 | 283 |
| 17 | 28.0 | 22.0 | 50.0 | 13.50 | 13.18 | 102.4 | 1489 | 1467 | 101.5 | G | 19.1 | 297 |
| 18 | 31.0 | - | 69.0 | 12.85 | 13.06 | 98.4 | 1479 | 1460 | 101.3 | G | 20.0 | 261 |
| 19 | 31.0 | 5.9 | 63.1 | 11.87 | 12.05 | 98.5 | 1514 | 1397 | 108.4 | G | 19.6 | 290 |
| 20 | 35.0 | - | 65.0 | 12.35 | 11.89 | 103.9 | 1484 | 1183 | 125.4 | G | 20.8 | 265 |
| 21 | 35.0 | 10.0 | 55.0 | 12.35 | 11.93 | 103.5 | 1436 | 1258 | 114.1 | G | 21.3 | 282 |
| 22 | 35.0 | 20.0 | 45.0 | 12.74 | 13.13 | 97.0 | 1442 | 1233 | 117.0 | G | 20.9 | 305 |
| 23 | 40.3 | - | 59.7 | 11.93 | 7.57 | 157.6 | 1477 | 684 | 215.9 | NG | 23.3 | 259 |
| 24 | 51.2 | - | 48.8 | 8.69 | 6.53 | 133.1 | 1493 | 425 | 351.3 | NG | 25.8 | 253 |
| 25 | 65.0 | - | 35.0 | 12.23 | 6.02 | 203.2 | 1478 | 388 | 380.9 | NG | 30.1 | 251 |

As apparent from Table 1 and Fig. 6, according to Samples 2 to 22 in which the content of the BaO-Re₂O₃-4TiO₂-based ceramic was within 10 to 35 percent by volume, although a relatively high relative dielectric constant was obtained, the rates of change in insulation resistance and Q value before and after the trimming were approximately 100%, that is, the insulation resistance and the Q value were hardly changed before and after the trimming.

On the other hand, in Sample 1, since the content of the BaO-Re₂O₃-4TiO₂-based ceramic was too low, although the insulation resistance and the Q value before and after the trimming were hardly changed, a sufficient relative dielectric constant could not be obtained as the dielectric glass ceramic layer. In addition, in Samples 23 to 25, since the Al₂O₃ ceramic was not contained, and the content of the BaO-Re₂O₃-4TiO₂-based ceramic was too high, although a sufficient relative dielectric constant could be obtained as the dielectric glass ceramic layer, the flexural strength unfavorably decreased, and in addition, the insulation resistance and the Q value were significantly changed before and after the trimming.

Next, it was found that as Sample 2 among Samples 2 to 22, when the total content of the BaO-Re₂O₃-4TiO₂-based ceramic and the Al₂O₃ ceramic was low and the content of the borosilicate glass was high, the relative dielectric constant tended to decrease. In addition, although not being shown in Table 1, it was found that as Sample 6, when the content of the Al₂O₃ ceramic was high and the content of the borosilicate glass was low, sufficient sintering was not likely to be performed at this firing temperature. In addition, it was also found that as Samples 10, 15, 18, and 20, when the Al₂O₃ ceramic was not contained, or the content thereof was low, the flexural strength tended to decrease. In addition, it was also found that as Samples 14 and 22, when the content of the borosilicate glass was low, sufficient sintering was not likely to be performed at this firing temperature.

### <Experimental Example 2>

Next, by using the composition of Sample 9 of Experimental Example 1, the thickness (element thickness) of the dielectric glass ceramic layer between the capacitor electrodes was changed as shown in the following Table 2, and in a manner similar to that in Experimental Example 1, the insulation resistance and the Q value were measured before and after the trimming. The results obtained by the above measurements are shown in the following Table 2.

**Table 2**

| **SAMPLE NO.** | **ELEMENT THICKNESS (µm)** | **INSULATION RESISTANCE (logIR)** | | | **Q VALUE at 1 MHz** | | |
|---|---|---|---|---|---|---|---|
| | | **BEFORE TRIMMING** | **AFTER TRIMMING** | **RATE OF CHANGE** | **BEFORE TRIMMING** | **AFTER TRIMMING** | **RATE OF CHANGE** |
| 31 | 5.0 | 13.01 | 5.86 | 222.0% | 2126 | 403 | 527.5% |
| 32 | 10.0 | 12.88 | 8.19 | 157.3% | 1950 | 931 | 209.5% |
| 33 | 12.5 | 12.91 | 11.89 | 108.6% | 1876 | 1789 | 104.9% |
| 34 | 25.0 | 12.91 | 12.77 | 101.1% | 1461 | 1458 | 100.2% |
| 35 | 50.0 | 11.75 | 11.33 | 103.7% | 1198 | 1201 | 99.8% |

As apparent from Table 2, as the element thickness decreased, the rates of change in insulation resistance and Q value before and after the trimming tended to increase, and in particular, when the element thickness was less than 12.5 µm, the rates of change in insulation resistance and Q value before and after the trimming significantly increased.

## Claims

1. A method for regulating the capacitance value of a built-in capacitor (2) of a multilayer ceramic substrate (1) which includes:
a ceramic laminate (6) having a plurality of ceramic layers (3, 4, 5) laminated to each other; and
a first and a second capacitor electrode (7, 8) disposed to face each other with a specific one (4) of the ceramic layers interposed therebetween so as to form the built-in capacitor,
the method comprising the step of performing laser trimming of the first capacitor electrode (7),
wherein the specific ceramic layer (4) disposed between the first and the second electrodes (7, 8) is a TiO₂-based dielectric glass ceramic layer which contains 10 to 35 percent by volume of dielectric grains (9) including TiO₂,
wherein the TiO₂-based dielectric glass ceramic layer (4) includes:
(A) 10 to 35 percent by volume of a BaO-TiO₂-ReO_{3/2}-based ceramic represented by xBaO-yTiO₂-zReO_{3/2}, where x, y, and z each indicate molar percent; 8≤x≤18, 52.5≤y≤65, and 20≤z≤40 hold; x+y+z=100 holds; and Re indicates a rare earth element;
(B) 5 to 42 percent by volume of an alumina ceramic; and
(C) 50 to 79 percent by volume of a borosilicate glass which includes 4 to 17.5 percent by weight of B₂O₃, 28 to 50 percent by weight of SiO₂, 0 to 20 percent by weight of Al₂O₃, and 36 to 50 percent by weight of MO, where MO is at least one selected from the group consisting of CaO, MgO, SrO, and BaO, and
the TiO₂-based dielectric glass ceramic layer is formed by firing a glass ceramic composition including the BaO-TiO₂-ReO_{3/2}-based ceramic and the alumina ceramic in a total amount of 21 percent by volume or more.

2. The method for regulating the capacitance value of a built-in capacitor, according to Claim 1, wherein the TiO₂-based dielectric glass ceramic layer (4) has a layer thickness of 12.5 to 50 µm.

3. The method for regulating the capacitance value of a built-in capacitor, according to Claim 1, wherein the first and the second capacitor electrodes (7, 8) are both built in the ceramic laminate (6).

4. The method for regulating the capacitance value of a built-in capacitor, according to Claim 3, wherein the borosilicate glass further includes less than 0.5 percent by weight of at least one selected from the group consisting of Li₂O, Na₂O, and K₂O.

5. A method for manufacturing a multilayer ceramic substrate, comprising the steps of:
forming a multilayer ceramic substrate (1) before being processed by trimming, which includes a ceramic laminate having a plurality of ceramic layers (3, 4, 5) laminated to each other, and a first and a second capacitor electrode (7, 8) disposed to face each other with a specific one (4) of the ceramic layers interposed therebetween so as to form a built-in capacitor; and
performing laser trimming of the first capacitor electrode (7) in order to regulate the capacitance value of the built-in capacitor,
wherein in the step of forming a multilayer ceramic substrate (1) before being processed by trimming, the specific ceramic layer (4) located between the first and the second capacitor electrodes (7, 8) is formed of a TiO₂-based dielectric glass ceramic layer in which the content of dielectric grains including TiO₂ is 10 to 35 percent by volume,
wherein the TiO₂-based dielectric glass ceramic layer (4) includes:
(A) 10 to 35 percent by volume of a BaO-TiO₂-ReO_{3/2}-based ceramic represented by xBaO-yTiO₂-zReO_{3/2}, where x, y, and z each indicate molar percent; 8≤x≤18, 52.5≤y≤65, and 20≤z≤40 hold; x+y+z=100 holds; and Re indicates a rare earth element;
(B) 5 to 42 percent by volume of an alumina ceramic; and
(C) 50 to 79 percent by volume of a borosilicate glass which includes 4 to 17.5 percent by weight of B₂O₃, 28 to 50 percent by weight of SiO₂, 0 to 20 percent by weight of Al₂O₃, and 36 to 50 percent by weight of MO, where MO is at least one selected from the group consisting of CaO, MgO, SrO, and BaO, and
the TiO₂-based dielectric glass ceramic layer is formed by firing a glass ceramic composition including the BaO-TiO₂-ReO_{3/2}-based ceramic and the alumina ceramic in a total amount of 21 percent by volume or more.

6. A multilayer ceramic substrate (1), comprising:
a ceramic laminate having a plurality of ceramic layers (3, 4, 5) laminated to each other; and
a first and a second capacitor electrode (7, 8) disposed to face each other with a specific one (4) of the ceramic layers interposed therebetween so as to form a built-in capacitor,
wherein the specific ceramic layer (4) located between the first and the second capacitor electrodes is a TiO₂-based dielectric glass ceramic layer in which the content of dielectric grains (9) including TiO₂ is 10 to 35 percent by volume, and
the first capacitor electrode (7) has a trimming track formed when the built-in capacitor is processed by laser trimming,
wherein the TiO₂-based dielectric glass ceramic layer (4) includes:
(A) 10 to 35 percent by volume of a BaO-TiO₂-ReO_{3/2}-based ceramic represented by xBaO-yTiO₂-zReO_{3/2}, where x, y, and z each indicate molar percent; 8≤x≤18, 52.5≤y≤65, and 20≤z≤40 hold; x+y+z=100 holds; and Re indicates a rare earth element/;
(B) 5 to 42 percent by volume of an alumina ceramic; and
(C) 50 to 79 percent by volume of a borosilicate glass which includes 4 to 17.5 percent by weight of B₂O₃, 28 to 50 percent by weight of SiO₂, 0 to 20 percent by weight of Al₂O₃, and 36 to 50 percent by weight of MO, where MO is at least one selected from the group consisting of CaO, MgO, SrO, and BaO, and
the TiO₂-based dielectric glass ceramic layer is formed by firing a glass ceramic composition including the BaO-TiO₂-ReO_{3/2}-based ceramic and the alumina ceramic in a total amount of 21 percent by volume or more.

## Patentansprüche

1. Ein Verfahren zum Regeln des Kapazitätswerts eines eingebauten Kondensators (2) eines Mehrschichtkeramiksubstrats (1), der folgende Merkmale umfasst:
ein Keramiklaminat (6) mit einer Mehrzahl von Keramikschichten (3, 4, 5), die aneinander laminiert sind; und
eine erste und eine zweite Kondensatorelektrode (7, 8), die angeordnet sind, um einander zugewandt zu sein mit einer spezifischen (4) der Keramikschichten dazwischen angeordnet, um den eingebauten Kondensator zu bilden,
wobei das Verfahren den Schritt des Durchführens von Lasertimmen der ersten Kondensatorelektrode (7) umfasst,
wobei die spezifische Keramikschicht (4), die zwischen der ersten und der zweiten Elektrode (7, 8) angeordnet ist, eine TiO₂-basierte dielektrische Glaskeramikschicht ist, die 10 bis 35 Volumenprozent dielektrische Körner (9) enthält, die TiO₂ umfassen,
wobei die TiO₂-basierte dielektrische Glaskeramikschicht (4) folgende Merkmale umfasst:
(A) 10 bis 35 Volumenprozent einer BaO-TiO₂-ReO_{3/2}-basierten Keramik, dargestellt durch xBaO-TiO₂-zReO_{3/2}, wobei x, y und z jeweils Molprozent anzeigen; 8 ≤ x ≤ 18, 52,5 ≤ y ≤ 65 und 20 ≤ z ≤ 40 gilt; x + y + z = 100 gilt; und Re ein Seltenerdmetall anzeigt;
(B) 5 bis 42 Volumenprozent einer Aluminiumoxidkeramik; und
(C) 50 bis 79 Volumenprozent eines Borosilikatglases, das 4 bis 17,5 Gewichtsprozent B₂O₃, 28 bis 50 Gewichtsprozent SiO₂, 0 bis 20 Gewichtsprozent Al₂O₃ und 36 bis 50 Gewichtsprozent MO umfasst, wobei MO zumindest eines ist, das aus der Gruppe ausgewählt ist, die aus CaO, MgO, SrO und BaO besteht, und
die TiO₂-basierte dielektrische Glaskeramikschicht gebildet wird durch Brennen einer Glaskeramikzusanammensetzung, die die BaO-TiO₂-ReO_{3/2}-basierte Keramik und die Aluminiumdioxidkeramik in einem Gesamtbetrag von 21 Volumenprozent oder mehr umfasst.

2. Das Verfahren zum Regeln des Kapazitätswerts eines eingebauten Kondensators gemäß Anspruch 1, bei dem die TiO₂-basierte dielektrische Glaskeramikschicht (4) eine Schichtdicke von 12,5 bis 50 µm aufweist.

3. Das Verfahren zum Regeln des Kapazitätswerts eines eingebauten Kondensators gemäß Anspruch 1, bei dem die erste und die zweite Kondensatorelektrode (7, 8) beide in das Keramiklaminat (6) eingebaut sind.

4. Das Verfahren zum Regeln des Kapazitätswerts eines eingebauten Kondensators gemäß Anspruch 3, bei dem das Borosilikatglas ferner weniger als 0,5 Gewichtsprozent von zumindest einem umfasst, das aus der Gruppe ausgewählt ist, die aus Li₂O, Na₂O und K₂O besteht.

5. Ein Verfahren zum Herstellen eines Mehrschichtkeramiksubsirats, das folgende Schritte aufweist:
Bilden eines Mehrschichtkeramiksubstrats (1), bevor dasselbe durch Trimmen verarbeitet wird, das ein Keramiklaminat mit einer Mehrzahl von Keramikschichten (3, 4, 5), die aneinander laminiert sind, und eine erste und eine zweite Kondensatorelektrode (7, 8) umfasst, die angeordnet sind, um einander gegenüber zu liegen mit einer spezifischen (4) der Keramikschichten zwischen denselben angeordnet, um einen eingebauten Kondensator zu bilden; und
Durchführen von Lasertrimmen der ersten Kondensatorelektrode (7), um den Kapazitätswert des eingebauten Kondensators zu regeln,
wobei bei dem Schritt des Bildens eines Mehrschichtkeramiksubstrats (1), bevor dasselbe durch Trimmen verarbeitet wird, die spezifische Keramikschicht (4), die zwischen der ersten und der zweiten Kondensatorelektrode (7, 8) angeordnet ist, aus einer TiO₂-basierten dielektrischen Glaskeramikschicht gebildet wird, bei der der Gehalt an dielektrischen Körnern, die TiO₂ enthalten, 10 bis 35 Volumenprozent beträgt,
wobei die TiO₂-basierte dielektrische Glaskeramikschicht (4) folgende Merkmale umfasst:
(A) 10 bis 35 Volumenprozent einer BaO-TiO₂-ReO_{3/2}-basierten Keramik, dargestellt durch xBaO-TiO₂-zReO_{3/2}, wobei x, y und z jeweils Molprozent anzeigen; 8 ≤ x ≤ 18, 52,5 ≤ y ≤ 65 und 20 ≤ z ≤ 40 gilt; x + y + z = 100 gilt; und Re ein Seltenerdmetall anzeigt;
(B) 5 bis 42 Volumenprozent einer Aluminiumoxidkeramik; und
(C) 50 bis 79 Volumenprozent eines Borosilikatglases, das 4 bis 17,5 Gewichtsprozent B₂O₃, 28 bis 50 Gewichtsprozent SiO₂, 0 bis 20 Gewichtsprozent Al₂O₃ und 36 bis 50 Gewichtsprozent MO umfasst, wobei MO zumindest eines ist, das aus der Gruppe ausgewählt ist, die aus CaO, MgO, SrO und BaO besteht, und
die TiO₂-basierte dielektrische Glaskeramikschicht gebildet wird durch Brennen einer Glaskeramikzusammensetzung, die die BaO-TiO₂-ReO_{3/2}-basierte Keramik und die Aluminiumdioxidkeramik in einem Gesamtbetrag von 21 Volumenprozent oder mehr enthält.

6. Ein Mehrschichtkeramiksubstrat (1), das folgende Merkmale ausweist:
ein Keramiklaminat mit einer Mehrzahl von Keramikschichten (3, 4, 5), die aneinander laminiert sind; und
eine erste und eine zweite Kondensatorelektrode (7, 8), die angeordnet sind, um einander zugewandt zu sein, mit einer spezifischen (4) der Keramikschichten dazwischen angeordnet, um einen eingebauten Kondensator zu bilden,
wobei die spezifische Keramikschicht (4), die zwischen der ersten und der zweiten Kondensatorelektrode angeordnet ist, eine TiO₂-basierte dielektrische Glaskeramikschicht ist, bei der der Gehalt an dielektrischen Körnern (9), die TiO₂ umfassen, 10 bis 35 Volumenprozent beträgt, und
die erste Kondensatorelektrode (7) eine Trimm-Spur aufweist, die gebildet wird, wenn der eingebaute Kondensator durch Lasertrimmen gebildet wird,
wobei die TiO₂-basierte dielektrische Glaskeramikschicht (4) folgende Merkmale umFasst:
(A) 10 bis 35 Volumenprozent einer BaO-TiO₂-ReO₃ₙ-basierten Keramik, dargestellt durch xBaO-TiO₂-zReO_{3/2}, wobei x, y und z jeweils Molprozent anzeigen; 8 ≤ X ≤ 18, 52,5 ≤ y ≤ 65 und 20 ≤ z ≤ 40 gilt; x + y + z = 100 gilt; und Re ein Seltenerdntetall anzeigt;
(B) 5 bis 42 Volumenprozent einer Aluminiumoxidkeramik; und
(C) 50 bis 79 Volumenprozent eines Borosilikatglases, das 4 bis 17,5 Gewichtsprozent B₂O₃, 28 bis 50 Gewichtsprozent SiO₂, 0 bis 20 Gewichtsprozent Al₂O₃ und 36 bis 50 Gewichtsprozent MO umfasst, wobei MO zumindest eines ist, das aus der Gruppe ausgewählt ist, die aus CaO, MgO, SrO und BaO besteht, und
die TiO₂-basierte dielektrische Glaskeramikschicht gebildet wird durch Brennen einer Glaskeramikzusammensetzung, die die BaO-TiO₂-Re0_{3/2}-basierte Keramik und der Aluminiumdioxidkeramik in einem Gesamtbetrag von 21 Volumenprozent oder mehr umfasst.

## Revendications

1. Procédé pour réguler la valeur de capacitance d'un condensateur intégré (2) d'un substrat en céramique multicouche (1) qui comprend :
un stratifié en céramique (6) ayant une pluralité de couches en céramique (3, 4, 5) stratifiées les unes aux autres ; et
des première et deuxième électrodes de condensateur (7, 8) disposées de façon à se faire face l'une l'autre, l'une spécifique (4) parmi les couches en céramique étant interposée entre elles de façon à former le condensateur intégré,
lequel procédé comprend l'étape consistant à effectuer un usinage au laser de la première électrode de condensateur (7),
dans lequel la couche en céramique spécifique (4) disposée entre les première et deuxième électrodes (7, 8) est une couche en vitrocéramique diélectrique à base de TiO₂ qui contient 10 à 35 % en volume de grains diélectriques (9) contenant du TiO₂,
dans lequel la couche en vitrocéramique diélectrique à base de TiO₂ (4) comprend :
(A) 10 à 35 % en volume d'une céramique à base de BaO-TiO₂-ReO_{3/2} représentée par xBaO-yTiO₂-zReO_{3/2} où chacun de x, y et z indique un pourcentage molaire ; 8 ≤ x ≤ 18, 52,5 ≤ y ≤ 65, et 20 ≤ z ≤ 40 s'appliquant ; x+y+z = 100 s'appliquant ; et Re indique un élément des terres rares ;
(B) 5 à 42 % en volume d'une céramique de type alumine ; et
(C) 50 à 79 % en volume d'un verre de borosilicate qui contient 4 à 17,5 % en poids de B₂O₃, 28 à 50 % en poids de SiO₂, 0 à 20 % en poids d'Al₂O₃, et 36 à 50 % en poids de MO, où MO est au moins l'un du groupe constitué par CaO, MgO, SrO et BaO, et
la couche en vitrocéramique diélectrique à base de TiO₂ est formée par cuisson d'une composition de vitrocéramique contenant la céramique à base de BaO-TiO₂-ReO_{3/2} et la céramique de type alumine en une quantité totale de 21 % en volume ou plus.

2. Procédé pour réguler la valeur de capacitance d'un condensateur intégré selon la revendication 1, dans lequel la couche en vitrocéramique diélectrique à base de TiO₂ (4) a une épaisseur de couche de 12,5 à 50 µm.

3. Procédé pour réguler la valeur de capacitance d'un condensateur intégré selon la revendication 1, dans lequel les première et deuxième électrodes de condensateur (7, 8) sont toutes deux intégrées dans le stratifié en céramique (6).

4. Procédé pour réguler la valeur de capacitance d'un condensateur intégré selon la revendication 3, dans lequel le verre de borosilicate contient en outre moins de 0,5 % en poids d'au moins l'un du groupe constitué par Li₂O, Na₂O et K₂O.

5. Procédé pour fabriquer un substrat en céramique multicouche, comprenant les étapes consistant à :
former un substrat en céramique multicouche (1) avant traitement par usinage, qui comprend un stratifié en céramique ayant une pluralité de couches en céramique (3, 4, 5) stratifiées les unes aux autres, et des première et deuxième électrodes de condensateur (7, 8) disposées de façon à se faire face l'une l'autre, l'une spécifique (4) parmi les couches en céramique étant interposée entre elles de façon à former un condensateur intégré ; et
effectuer un usinage au laser de la première électrode de condensateur (7) afin de réguler la valeur de capacitance du condensateur intégré,
dans lequel, dans l'étape de formation d'un substrat en céramique multicouche (1) avant traitement par usinage, la couche en céramique spécifique (4) localisée entre les première et deuxième électrodes de condensateur (7, 8) est formée d'une couche en vitrocéramique diélectrique à base de TiO₂ dans laquelle la teneur en grains diélectriques contenant du TiO₂ est de 10 à 35 % en volume,
dans lequel la couche en vitrocéramique diélectrique à base de TiO₂ (4) comprend :
(A) 10 à 35 % en volume d'une céramique à base de BaO-TiO₂-ReO_{3/2} représentée par xBaO-yTiO₂-zReO_{3/2} où chacun de x, y et z indique un pourcentage molaire ; 8 ≤ x ≤ 18, 52,5 ≤ y ≤ 65, et 20 ≤ z ≤ 40 s'appliquant ; x+y+z = 100 s'appliquant ; et Re indique un élément des terres rares ;
(B) 5 à 42 % en volume d'une céramique de type alumine ; et
(C) 50 à 79 % en volume d'un verre de borosilicate qui contient 4 à 17,5 % en poids de B₂O₃, 28 à 50 % en poids de SiO₂, 0 à 20 % en poids d'Al₂O₃, et 36 à 50 % en poids de MO, où MO est au moins l'un du groupe constitué par CaO, MgO, srO et BaO, et
la couche en vitrocéramique diélectrique à base de TiO₂ est formée par cuisson d'une composition de vitrocéramique contenant la céramique à base de BaO-TiO₂-ReO_{3/2} et la céramique de type alumine en une quantité totale de 21 % en volume ou plus.

6. Substrat en céramique multicouche (1) comprenant :
un stratifié en céramique ayant une pluralité de couches en céramique (3, 4, 5) stratifiées les unes aux autres ; et
des première et deuxième électrodes de condensateur (7, 8) disposées de façon à se faire face l'une l'autre, l'une spécifique (4) parmi les couches en céramique étant interposée entre elles de façon à former le condensateur intégré,
dans lequel la couche en céramique spécifique (4) disposée entre les première et deuxième électrodes est une couche en vitrocéramique diélectrique à base de TiO₂ dans laquelle la teneur en grains diélectriques (9) contenant du TiO₂ est de 10 à 35 % en volume, et
la première électrode de condensateur (7) a une piste d'usinage formée lors du traitement du condensateur intégré par un usinage au laser,
dans lequel la couche en vitrocéramique diélectrique à base de TiO₂ (4) comprend :
(A) 10 à 35 % en volume d'une céramique à base de BaO-TiO₂-ReO_{3/2} représentée par xBaO-yTiO₂-zReO_{3/2} où chacun de x, y et z indique un pourcentage molaire ; 8 ≤ x ≤ 18, 52,5 ≤ y ≤ 65, et 20 ≤ z ≤ 40 s'appliquant ; x+y+z = 100 s'appliquant ; et Re indique un élément des terres rares ;
(B) 5 à 42 % en volume d'une céramique de type alumine ; et
(C) 50 à 79 % en volume d'un verre de borosilicate qui contient 4 à 17,5 % en poids de B₂O₃, 28 à 50 % en poids de SiO₂, 0 à 20 % en poids d'Al₂O₃, et 36 à 50 % en poids de MO, où MO est au moins l'un du groupe constitué par CaO, MgO, SrO et BaO, et
la couche en vitrocéramique diélectrique à base de TiO₂ est formée par cuisson d'une composition de vitrocéramique contenant la céramique à base de BaO-TiO₂-ReO_{3/2} et la céramique de type alumine en une quantité totale de 21 % en volume ou plus.
